# EUROPÄISCHE PATENTANMELDUNG

(11) **EP 3 975 066 A1**
(43) Veröffentlichungstag der Anmeldung: **30.03.2022**
(21) Anmeldenummer: 21195219.7
(22) Anmeldetag: 07.09.2021
(51) Int. Cl.: G06N 5/00

(54) **VERFAHREN ZUR ÜBERPRÜFUNG EINER TECHNISCHEN FUNKTION EINER ELEKTRISCHEN UND/ODER MECHANISCHEN ERSTEN VORRICHTUNG EINES EISENBAHNSYSTEMS**

(30) Priorität: 25.09.2020 DE 102020212127
(71) Anmelder: Siemens Mobility GmbH, 81739 München (DE)
(72) Erfinder: Blum, Karsten, 38106 Braunschweig (DE); Sauter, Witali, 38116 Braunschweig (DE)

(57) **Zusammenfassung**

Die Erfindung betrifft ein computerimplementiertes Verfahren zum Überprüfen einer technischen Funktion einer elektrischen und/oder mechanischen ersten Vorrichtung eines Eisenbahnsystems, insbesondere einer ersten Vorrichtung eines Zuges oder einer Gleisinfrastruktur, wobei ein technischer Zustand der ersten Vorrichtung in zeitlichen Abständen erfasst wird, wobei die erfassten technischen Zustände der ersten Vorrichtung als erstes zeitliches Verhalten abgespeichert werden, wobei ein technischer Zustand einer zweiten Vorrichtung des Eisenbahnsystems in zeitlichen Abständen erfasst wird, wobei die erfassten technischen Zustände der zweiten Vorrichtung als zweites zeitliches Verhalten abgespeichert werden, wobei die zweite Vorrichtung gemäß wenigstens einem technischen Parameter ähnlich oder identisch zur ersten Vorrichtung ist, wobei bei Auftreten einer ersten Fehlfunktion der ersten Vorrichtung das erste zeitliche Verhalten als zeitliches Referenzverhalten ermittelt wird, und wobei anhand des Referenzverhaltens und anhand des zweiten zeitlichen Verhaltens ein Zeitpunkt abgeschätzt wird, bei dem bei der zweiten Vorrichtung eine Fehlfunktion auftreten wird.

## Beschreibung

Die Erfindung betrifft ein Verfahren zum Überprüfen einer technischen Funktion einer elektrischen und/oder mechanischen ersten Vorrichtung eines Eisenbahnsystems.

Vorrichtungen von Zügen und Vorrichtungen der Gleisinfrastruktur müssen insbesondere bei sicherheitstechnischen Funktionen korrekt funktionieren, und deren Funktion muss gewährleistet sein. Zur Überprüfung der Funktion der Vorrichtungen eines Eisenbahnsystems sind Diagnosesysteme bekannt, die bei einer Störung der Vorrichtung eine Störmeldung an eine Zentrale liefern.

Die Aufgabe der Erfindung besteht darin, die Funktionsfähigkeit der Vorrichtungen des Eisenbahnsystems zu verbessern.

Die Aufgaben der Erfindung werden durch die unabhängigen Patentansprüche gelöst.

Es wird ein computerimplementiertes Verfahren zum Überprüfen einer technischen Funktion einer elektrischen und/oder mechanischen ersten Vorrichtung eines Eisenbahnsystems vorgeschlagen. Dazu wird ein technischer Zustand der ersten Vorrichtung in zeitlichen Abständen erfasst und die erfassten technischen Zustände als erstes zeitliches Verhalten der ersten Vorrichtung abgespeichert. Zudem wird ein technischer Zustand einer zweiten Vorrichtung des Eisenbahnsystems in zeitlichen Abständen erfasst und die erfassten Zustände der zweiten Vorrichtung werden als zweites zeitliches Verhalten abgespeichert. Die erste und die zweite Vorrichtung können beispielsweise eine Vorrichtung eines Zuges oder einer Gleisinfrastruktur sein.

Die technischen Zustände der ersten oder zweiten Vorrichtung können physikalische Größen wie beispielsweise Strom, Spannung, Geschwindigkeit usw. darstellen. Insbesondere sind die erfassten technischen Zustände der ersten oder zweiten Vorrichtung ähnliche oder identische technische Zustände. Zudem sind die erste und die zweite Vorrichtung wenigstens in einem technischen Parameter ähnlich oder identisch, insbesondere sind die erste und die zweite Vorrichtung identisch ausgebildet.

Bei Auftreten einer Fehlfunktion der ersten Vorrichtung wird das erste zeitliche Verhalten der technischen Zustände der ersten Vorrichtung als zeitliches Referenzverhalten festgelegt. Anschließend wird anhand des Referenzverhaltens und anhand des zweiten zeitlichen Verhaltens der zweiten Vorrichtung ein Zeitpunkt abgeschätzt, bei dem eine Fehlfunktion der zweiten Vorrichtung auftreten wird. Anhand des Referenzverhaltens und anhand des zweiten zeitlichen Verhaltens wird das zweite zeitliche Verhalten in der Weise approximiert, dass ein Zeitpunkt für das Auftreten einer Fehlfunktion abgeschätzt werden kann. Auf diese Weise ist es möglich, eine Fehlfunktion der zweiten Vorrichtung vorherzusagen. Dadurch kann beispielsweise eine vorbeugende Wartung oder Reparatur der zweiten Vorrichtung vorgenommen werden, bevor die zweite Vorrichtung eine Fehlfunktion aufweist. Dies ist insbesondere bei sicherheitstechnischen Funktionen der zweiten Vorrichtung von Vorteil. Auf diese Weise kann die Wartung der zweiten Vorrichtung effizienter und der Betreib der zweiten Vorrichtung mit einer geringeren Ausfallzeit der zweiten Vorrichtung durchgeführt werden. Für eine einfache Abschätzung des zweiten zeitlichen Verhaltens kann die Steigung des Referenzverhaltens als zukünftiges Verhalten für das zweite zeitliche Verhalten verwendet werden und der Zeitpunkt zu dem das Auftreten einer Fehlfunktion der zweiten Vorrichtung erwartet wird, anhand des Zeitpunktes des Auftretens der Fehlfunktion der ersten Vorrichtung abgeschätzt werden. In einer Ausführung können die erste und die zweite Vorrichtung eine einzige Vorrichtung darstellen, wobei das erste und das zweite zeitliche Verhalten zeitlich nacheinander erfasste zeitliche Verhalten einer einzigen Vorrichtung darstellen. Somit kann aus dem historischen Verhalten einer bestimmten Vorrichtung die Wartung dieser Vorrichtung für die Zukunft besser geplant werden. In diesem Fall stellt das Referenzverhalten ein früheres zeitliches Verhalten der Vorrichtung dar.

In einer Ausführungsform wird ein technischer Zustand einer dritten Vorrichtung in zeitlichen Abständen erfasst und als drittes zeitliches Verhalten abgespeichert. Die technischen Zustände der dritten Vorrichtung können physikalische Größen wie beispielsweise Strom, Spannung, Geschwindigkeit usw. darstellen. Insbesondere sind die erfassten technischen Zustände der dritten Vorrichtung ähnlich oder identisch zu den erfassten technischen Zuständen der ersten und/oder der zweiten Vorrichtung. Zudem sind die erste und die zweite Vorrichtung wenigstens in einem technischen Parameter ähnlich oder identisch, insbesondere sind die erste und die zweite Vorrichtung identisch ausgebildet.

Die dritte Vorrichtung ist wenigstens in einem technischen Parameter ähnlich oder identisch zur ersten oder zweiten Vorrichtung. Insbesondere ist die dritte Vorrichtung identisch zur ersten und/oder zur zweiten Vorrichtung. Bei Auftreten einer dritten Fehlfunktion, die wenigstens in einem Parameter ähnlich oder identisch zur ersten Fehlfunktion ist, wird abhängig von dem ersten und dem dritten zeitlichen Verhalten das Referenzverhalten gebildet.

In einer Ausführung werden nach wenigstens einem vorgegebenen Kriterium beim ersten zeitlichen Verhalten ein zeitlicher erster Beginn einer Verschlechterung der Funktion der ersten Vorrichtung und beim dritten zeitlichen Verhalten ein zeitlicher dritter Beginn der Verschlechterung der Funktion der dritten Vorrichtung ermittelt. Die vorgegebenen Kriterien können für die erste und dritte Vorrichtung identisch oder unterschiedlich sein. Abhängig von dem ersten Beginn einer Verschlechterung der Funktion der ersten Vorrichtung und dem dritten Beginn der Verschlechterung der Funktion der dritten Vorrichtung wird nach einem vorgegebenen Verfahren ein zeitlicher Beginn der Verschlechterung der Funktion für das zeitliche Referenzverhalten ermittelt. In einer einfachen Ausführung kann ein Mittelwert zwischen dem ersten und dem dritten Beginn als zeitlicher Beginn der Verschlechterung der Funktion für das zeitliche Referenzverhalten bestimmt werden. Das vorgegebene Kriterium kann eine vorgegebene Steigung des ersten und des dritten zeitlichen Verhaltens, vorgegebenen Veränderungen der Werte der erfassten technischen Zustände der ersten und der dritten Vorrichtung, insbesondere in Wertesprüngen usw. sein.

Das Referenzverhalten wird verwendet, um den Zeitpunkt abzuschätzen, zu dem eine Fehlfunktion bei der zweiten Vorrichtung auftreten wird. Da das Referenzverhalten anhand des ersten und des dritten zeitlichen Verhaltens ermittelt wird, wird ein präziseres Referenzverhalten ermittelt. Dadurch kann eine genauere Abschätzung des Zeitpunktes des Auftretens der Fehlfunktion der zweiten Vorrichtung erreicht werden. Die Ermittlung des Referenzverhaltens ist nicht auf zwei zeitliche Verhalten von zwei Vorrichtungen beschränkt. In der Regel wird ein umso präziseres Referenzverhalten ermittelt, je mehr zeitliche Verhalten von ähnlichen, insbesondere identischen Vorrichtungen zur Bildung des Referenzverhaltens berücksichtigt werden. Insbesondere wird die Qualität des Referenzverhaltens verbessert, wenn die Vorrichtungen, deren zeitliche Verhalten zur Bildung des Referenzverhaltens verwendet werden, möglichst ähnliche, insbesondere identische Fehlfunktionen aufweisen. Zudem wird die Abschätzung des Zeitpunktes für das Auftreten der Fehlfunktion der zweiten Vorrichtung umso genauer, je identischer die zweite Vorrichtung zur ersten und/oder zur dritten Vorrichtung ausgebildet ist. Unabhängig davon können zeitliche Verhalten von Vorrichtungen zur Bildung des Referenzverhaltens verwendet werden, die nicht identisch ausgebildet sind, sondern sich in Teilbereichen im Aufbau und/oder in der Funktion unterscheiden, die jedoch insbesondere das Auftreten der Fehlfunktion wesentlich beeinflussen. Ebenso kann auch der Zeitpunkt des Auftretens einer Fehlfunktion für zweite Vorrichtungen abgeschätzt werden, die nicht identisch zur ersten und/oder zur dritten Vorrichtung ausgebildet sind, sondern sich im Aufbau und/oder in der Funktion unterscheiden.

In einer Ausführungsform sind die erste, die zweite und die dritte Vorrichtung in Bezug auf eine elektrische Schaltung und/oder eine mechanische Konstruktion wenigstens ähnlich oder identisch ausgebildet, wobei die Schaltung oder die Konstruktion das Auftreten der Fehlfunktion wesentlich beeinflusst oder die Fehlfunktion die Schaltung oder die Konstruktion betrifft. Insbesondere können die erste, die zweite und die dritte Vorrichtung eine identische technische Funktion und/oder eine identische elektrische und/oder mechanische Ausbildung aufweisen. Je genauer die erste und die dritte Vorrichtung übereinstimmen, umso genauer kann das Referenzverhalten ermittelt werden. Umso identischer die zweite Vorrichtung zur ersten und/oder zur dritten Vorrichtung ausgebildet ist, umso genauer kann der Zeitpunkt zum Auftreten der zweiten Vorrichtung abgeschätzt werden.

In einer Ausführungsform sind die Fehlfunktion der ersten, der zweiten und der dritten Vorrichtung wenigstens ähnlich oder identisch ausgebildet. Je ähnlicher die Fehlfunktion der ersten und der dritten Vorrichtung sind, umso präziser kann das Referenzverhalten ermittelt werden. Zudem kann der Zeitpunkt zum Auftreten der Fehlfunktion der zweiten Vorrichtung umso präziser ermittelt werden, je ähnlicher die Fehlfunktion der zweiten Vorrichtung ausgebildet ist.

In einer weiteren Ausführungsform wird zusätzlich zu den technischen Zuständen der Vorrichtungen wenigstens ein zeitliches Verhalten eines Messwertes für eine Umgebungsbedingung, insbesondere für eine Temperatur, und/eine Feuchtigkeit und/oder eine Gaszusammensetzung und/oder eine Sonneneinstrahlung am Ort der Vorrichtung erfasst und als zeitliches Messverhalten der Vorrichtung abgespeichert. Das zeitliche Messverhalten der der ersten und der dritten Vorrichtung kann zusätzlich zur Ermittlung des zeitlichen Referenzverhaltens berücksichtigt werden. Insbesondere kann das zeitliche Messwertverhalten als zeitliches Referenzmesswertverhalten zur Abschätzung des Zeitpunktes des Auftretens der Fehlfunktion der zweiten Vorrichtung verwendet werden. Zudem kann das zeitliche Messwertverhalten der zweiten Vorrichtung bei der Abschätzung des Zeitpunktes des Auftretens der Fehlfunktion der zweiten Vorrichtung zusammen mit dem Referenzmesswertverhalten verwendet werden. Auf diese Weise wird eine präzisere Abschätzung für den Zeitpunkt des Auftretens der Fehlfunktion der zweiten Vorrichtung ermöglicht.

In einer weiteren Ausführungsform kann eine örtliche Umgebungsbedingung der Vorrichtungen abgespeichert werden, wobei die Umgebungsbedingungen der Vorrichtungen zusätzlich bei der Ermittlung des zeitlichen Referenzverhaltens berücksichtigt werden. Somit können unterschiedliche Umgebungsbedingungen bei der Bildung des Referenzverhaltens berücksichtigt werden. Auf diese Weise wird eine präzisere Ermittlung des Referenzverhaltens ermöglicht.

In einer weiteren Ausführungsform kann eine örtliche Umgebungsbedingung der zweiten Vorrichtung bei der Ermittlung des Zeitpunktes des Auftretens der Fehlfunktion berücksichtigt werden. Auf diese Weise wird eine präzisere Ermittlung des Zeitpunktes des Auftretens der Fehlfunktion ermöglicht.

In einer Ausführungsform wird vor dem abgeschätzten Zeitpunkt, zu dem bei der zweiten Vorrichtung eine Fehlfunktion erwartet wird, ein Hinweis ausgegeben und/oder automatisch eine Wartung der zweiten Vorrichtung durchgeführt. Auf diese Weise wird die Wartung der zweiten Vorrichtung verbessert, insbesondere ein Ausfall der zweiten Vorrichtung vermieden.

In einer weiteren Ausführungsform werden als technischer Zustand ein Strom und/oder eine Spannung und/oder eine Temperatur der Vorrichtung erfasst. Zudem kann als Zustand der Vorrichtung eine Geschwindigkeit wenigstens eines bewegbaren Teiles der Vorrichtung erfasst werden. Diese Parameter können in vielen Fällen eine Aussage über die Funktionsfähigkeit einer technischen Vorrichtung geben.

In einer weiteren Ausführungsform wird zur Ermittlung des Referenzverhaltens eine Mittelung zwischen dem ersten und dem dritten zeitlichen Verhalten der ersten und der dritten Vorrichtung vorgenommen und als Referenzverhalten verwendet. Somit kann das Referenzverhalten auf einfache Weise festgelegt werden.

In einer weiteren Ausführungsform kann durch einen Vergleich des zeitlichen Referenzverhaltens mit dem zweiten zeitlichen Verhalten ein Zeitpunkt ermittelt werden, ab dem das Auftreten einer Fehlfunktion bei der zweiten Vorrichtung erkennbar ist. Dazu können entsprechende Vergleichswerte abgelegt sein.

In einer Ausführung wird abhängig von einem vorgegebenen Verfahren ein Zeitpunkt am zeitlichen Referenzverhalten ermittelt, der den Beginn einer Verschlechterung der Funktion für das Referenzverhalten festlegt. Zudem wird eine Zeitspanne zwischen dem Beginn der Verschlechterung und dem Auftreten der Fehlfunktion des Referenzverhaltens ermittelt. Die Zeitspanne kann für das erste und das dritte zeitliche Verhalten getrennt ermittelt werden. Die Zeitspanne für das Referenzverhalten kann abhängig von den Zeitspannen des ersten und/oder dritten zeitlichen Verhaltens ermittelt werden. In einer einfachen Ausführung wird die Zeitspanne für das Referenzverhalten aus einem Mittelwert der Zeitspannen des ersten und dritten zeitlichen Verhaltens gebildet.

Durch einen Vergleich des zeitlichen Referenzverhaltens mit dem zweiten zeitlichen Verhalten wird ein zweiter Zeitpunkt des zeitlichen Verhaltens der zweiten Vorrichtung ermittelt, ab dem das Auftreten einer Fehlfunktion bei der zweiten Vorrichtung erkennbar ist. Der Zeitpunkt des Auftretens der Fehlfunktion der zweiten Vorrichtung wird durch den Zeitpunkt des Referenzverhaltens und einem entsprechenden Zeitpunkt des zweiten zeitlichen Verhaltens und der ermittelten Zeitspanne abgeschätzt. Das Auftreten der Fehlfunktion der zweiten Vorrichtung wird ausgehend von dem entsprechenden Zeitpunkt des zweiten zeitlichen Verhaltens und nach Ablauf der ermittelten Zeitspanne erwartet.

Abhängig von der gewählten Ausführungsform können die dritte, die zweite und/oder die erste Vorrichtung eine Weiche für ein Zuggleis, eine Signalanzeige eines Zuges oder eine Signalanzeige einer Gleisinfrastruktur, ein Gleisbett eines Zuggleises oder ein Achszählsystem für Züge darstellen.

Zudem wird eine Vorrichtung zum Überprüfen einer technischen Funktion einer elektrischen und/oder mechanischen Vorrichtung eines Eisenbahnsystems, insbesondere eines Zuges oder einer Gleisinfrastruktur, vorgeschlagen, wobei die Vorrichtung eine Recheneinheit, einen Datenspeicher, einen Dateneingang und einen Steuerausgang aufweist. Über den Dateneingang werden technische Zustände der ersten Vorrichtung empfangen. Die Recheneinheit ermittelt anhand der erfassten technischen Zustände ein erstes zeitliches Verhalten des technischen Zustandes der ersten Vorrichtung und speichert das erste zeitliche Verhalten im Datenspeicher ab. Zudem werden über den Dateneingang technische Zustände der zweiten Vorrichtung empfangen. Die Recheneinheit ermittelt anhand der erfassten technischen Zustände ein zweites zeitliches Verhalten des technischen Zustandes der zweiten Vorrichtung und speichert dieses im Datenspeicher ab. Zudem wird über den Dateneingang ein Auftreten einer ersten Fehlfunktion der ersten Vorrichtung empfangen. Nach Empfang der Fehlfunktion der ersten Vorrichtung wird das erste zeitliche Verhalten als zeitliches Referenzverhalten festgelegt und im Datenspeicher abgelegt. Die Recheneinheit schätzt anhand des Referenzverhaltens und anhand des zweiten zeitlichen Verhaltens einen Zeitpunkt ab, bei dem eine Fehlfunktion der zweiten Vorrichtung auftreten wird. Dazu verwendet die Recheneinheit beispielsweise das Referenzverhalten und approximiert das zweite zeitliche Verhalten analog zum Referenzverhalten und schätzt den Zeitpunkt für das Auftreten der Fehlfunktion der zweiten Vorrichtung gemäß dem Auftreten der Fehlfunktion gemäß dem Referenzverhalten der ersten Vorrichtung ab.

In einer Ausführungsform wird das Referenzverhalten nicht nur durch das erste zeitliche Verhalten, sondern auch durch das dritte zeitliche Verhalten von technischen Zuständen der dritten Vorrichtung ermittelt.

Zudem wird ein Computerprogrammprodukt bereitgestellt, das ausgebildet ist, das Verfahren auszuführen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
- FIG 1: eine schematische Darstellung einer Anordnung zur Durchführung des Verfahrens,
- FIG 2: eine schematische Darstellung eines Programmablaufes zur Erläuterung eines Verfahrens zur Abschätzung des Zeitpunktes, zu dem bei der zweiten Vorrichtung eine Fehlfunktion auftreten wird, und
- FIG 3: ein Diagramm zur Erläuterung einer weiteren Ausführungsform des Verfahrens zur Abschätzung des Zeitpunktes, zu dem bei der zweiten Vorrichtung eine Fehlfunktion auftreten wird, zeigen.

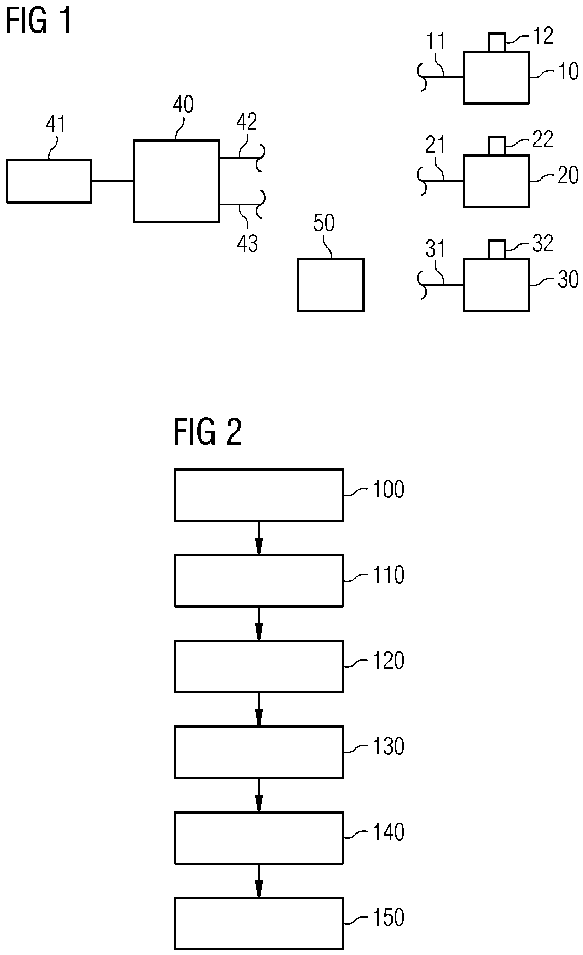

FIG 1 zeigt in einer schematischen Darstellung eine erste Vorrichtung 10, eine zweite Vorrichtung 20 und eine dritte Vorrichtung 30. Die erste, die zweite und die dritte Vorrichtung 10, 20, 30 stellen elektrische und/oder mechanische Vorrichtungen eines Eisenbahnsystems, insbesondere eines Zuges oder einer Gleisinfrastruktur dar. Beispielsweise können die erste, die zweite und/oder die dritte Vorrichtung eine Weiche für ein Zuggleis, eine Signalanzeige innerhalb eines Zuges oder an einem Zuggleis, ein Gleisbett, eine Stromversorgung eines Gleisbettes mit Anschluss an den zwei Schienen eines Gleises und/oder ein Achszählsystem für Züge darstellen. Abhängig von der gewählten Ausführungsform können die drei Vorrichtungen ähnlich oder identisch ausgebildet sein. Beispielsweise können die drei Vorrichtungen Weichenantriebe für Weichen eines Weichenstellsystems für Zuggleise darstellen. Zudem können die drei Vorrichtungen jeweils vom gleichen Vorrichtungstyp, d.h. jeweils eine Weiche, einen Weichenantrieb eines Weichenstellsystems, eine Signalanzeige, ein Gleisbett, eine Stromversorgung insbesondere für ein Gleisbett oder ein Achszählsystem für einen Zug darstellen. Die drei Vorrichtungen können sich, obwohl sie vom gleichen Typ sind, sich in einzelnen Details unterscheiden können. Zudem können die drei Vorrichtungen identisch ausgebildet sein.

Weiterhin ist eine Recheneinheit 40 vorgesehen, die mit einem Datenspeicher 41 verbunden ist. Zudem weist die Recheneinheit 40 einen Dateneingang 42 und einen Steuerausgang 43 auf. Die Recheneinheit 40 ist ausgebildet, um eine technische Funktion einer elektrischen und/oder einer mechanischen Vorrichtung eines Eisenbahnsystems zu überprüfen. Der Dateneingang 42 ist mit Datenausgängen 11, 21, 31 der ersten, der zweiten und der dritten Vorrichtung 10, 20, 30 verbunden. Über den Dateneingang 42 empfängt die Recheneinheit 40 technische Zustände der ersten, zweiten und dritten Vorrichtung 10, 20, 30. Die technischen Zustände der Vorrichtungen können beispielsweise Schaltzustände der Vorrichtungen und/oder physikalische Messgrößen der Vorrichtungen, wie z.B. Strom, Spannung, Bewegungsgeschwindigkeit wenigstens eines Teils der Vorrichtung sein.

Zudem kann jede Vorrichtung über einen Sensor 12, 22, 32 verfügen bzw. im Bereich der Vorrichtung ein Sensor 12, 22, 32 vorgesehen sein. Mit Hilfe der Sensoren 12, 22, 32 werden Messwerte für eine Umgebungsbedingung der Vorrichtungen 10, 20, 30 erfasst. Beispielsweise kann die Umgebungsbedingung in einer Temperatur und/oder einer Feuchtigkeit und/oder einer Gaszusammensetzung und/oder einer Sonneneinstrahlung am Ort der Vorrichtung sein. Die Messwerte der Sensoren können zudem über entsprechende nicht dargestellt Datenverbindungen an den Dateneingang 42 der Recheneinheit 40 geliefert werden.

Die Recheneinheit 40 ist ausgebildet, um in zeitlichen Abständen die technischen Zustände der ersten, zweiten und/oder dritten Vorrichtung zu erfassen. In einer einfachen Ausführung können nur die erste und die zweite Vorrichtung 10, 20 oder mehr als drei Vorrichtungen vorgesehen sein. Die Recheneinheit 40 ermittelt anhand der erfassten technischen Zustände der ersten Vorrichtung ein erstes zeitliches Verhalten des technischen Zustandes der ersten Vorrichtung und speichert dieses im Datenspeicher 41 ab. Zudem ermittelt die Recheneinheit 40 anhand der erfassten technischen Zustände der zweiten Vorrichtung ein zweites zeitliches Verhalten des technischen Zustandes der zweiten Vorrichtung und speichert dieses im Datenspeicher ab. Weiterhin ermittelt die Recheneinheit 40 anhand der erfassten technischen Zustände der dritten Vorrichtung ein drittes zeitliches Verhalten des technischen Zustandes der dritten Vorrichtung und speichert dieses im Datenspeicher 41 ab. Tritt eine Fehlfunktion beispielsweise bei der ersten Vorrichtung 10 auf, die von der Recheneinheit 40 über den Dateneingang 42 erfasst wird, so wird das erste zeitliche Verhalten für die Ermittlung eines zeitlichen Referenzverhaltens verwendet. Die Fehlfunktion der ersten Vorrichtung 10 kann beispielsweise über einen Fehlalarm der ersten Vorrichtung 10 von der Recheneinheit 40 erkannt werden. Zudem kann die Recheneinheit 40 beispielsweise aufgrund des empfangenen technischen Zustandes der ersten Vorrichtung 10 durch einen Vergleich mit einem im Datenspeicher abgelegten Vergleichswert selbst eine Fehlfunktion der ersten Vorrichtung 10 erkennen.

Im Datenspeicher 40 sind Vergleichswerte, Grenzwerte, Formeln und/oder Algorithmen abgelegt, mit denen anhand des ersten zeitlichen Verlaufes die Recheneinheit 40 ein zeitliches Referenzverhalten ermittelt wird. Dabei kann in einem einfachen Fall ein Zeitpunkt für den Beginn einer Verschlechterung der Funktion der Vorrichtung nach festgelegten Regeln ermittelt werden. In einem einfachen Fall kann z.B. anhand von zwei zeitlich aufeinander folgenden und abgespeicherten Werten des technischen Zustandes einer Vorrichtung der Beginn der Verschlechterung der Funktion der Vorrichtung erkannt werden. Beispielsweise wird der Beginn der Verschlechterung der Funktion der Vorrichtung erkannt, wenn der Unterschied von zwei zeitlich aufeinander folgenden und abgespeicherten technischen Zuständen eine vorgegebene Bedingung erfüllt. Beispielsweise kann die vorgegebene Bedingung ein Überschreiten oder Unterschreiten eines definierten Grenzwertes sein. Zudem kann z.B. der Beginn der Verschlechterung der Funktion anhand einer vorgegebenen Kennlinienänderung ermittelt werden, wobei die Kennlinie durch die erfassten Zustände der Vorrichtung gebildet wird. Zudem kann z.B. der Beginn der Verschlechterung der Funktion anhand einer vorgegebenen Kennlinienstruktur ermittelt werden, wobei die Kennlinie durch die erfassten Zustände der Vorrichtung gebildet wird.

Die Recheneinheit 40 ermittelt die Zeitdifferenz zwischen dem Beginn der Verschlechterung der Funktion der ersten Vorrichtung und dem Auftreten der Fehlfunktion der ersten Vorrichtung.

Zudem ist die Recheneinheit 40 ausgebildet, um das zweite zeitliche Verhalten der zweiten Vorrichtung anhand des Referenzverhaltens in die Zukunft zu approximieren und einen Zeitpunkt für eine Fehlfunktion der zweiten Vorrichtung abzuschätzen. Dazu sind entsprechende Verfahren im Datenspeicher 41 abgelegt. Dazu erfasst die Recheneinheit den Beginn der Verschlechterung der Funktion der zweiten Vorrichtung vorzugsweise mit dem gleichen Verfahren wie bei der ersten Vorrichtung. Erkennt die Recheneinheit den zeitlichen Beginn der Verschlechterung der Funktion der zweiten Vorrichtung, dann schätzt die Recheneinheit das Auftreten der Fehlfunktion der zweiten Vorrichtung in der Zukunft nach dem Ablauf der ermittelten Zeitdifferenz, der für die erste Vorrichtung zwischen dem Beginn der Verschlechterung der Funktion und dem zeitlichen Auftreten der Fehlfunktion lag.

In einer weiteren Ausführungsform erfasst die Recheneinheit 40 über den Dateneingang 42 eine Fehlfunktion der dritten Vorrichtung. Abhängig von der gewählten Ausführungsform kann zusätzlich zum ersten zeitlichen Verhalten das dritte zeitliche Verhalten verwendet werden, um das Referenzverhalten zu bilden, wenn bei der dritten Vorrichtung auch eine Fehlfunktion aufgetreten ist. Dabei kann in einem einfachen Fall ein Zeitpunkt für den zeitlichen Beginn einer Verschlechterung der Funktion der dritten Vorrichtung nach festgelegten Regeln ermittelt werden. Dazu können die gleichen Verfahren wie bei der Ermittlung des zeitlichen Beginns der Verschlechterung der Funktion der ersten Vorrichtung verwendet werden. Die Recheneinheit 40 ermittelt die Zeitdifferenz zwischen dem Beginn der Verschlechterung der Funktion der dritten Vorrichtung und dem Auftreten der Fehlfunktion der dritten Vorrichtung.

Die Art und Weise, wie das aus dem ersten zeitlichen Verhalten und dem dritten zeitlichen Verhalten ein Referenzverhalten gebildet wird, ist im Datenspeicher 41 anhand von Formeln und/oder Algorithmen abgelegt. In einem einfachen Fall kann als zeitlicher Beginn der Verschlechterung des Referenzverhaltens ein Mittelwert zwischen dem zeitlichen Beginn der Verschlechterung der ersten Vorrichtung und dem zeitlichen Beginn der Verschlechterung der dritten Vorrichtung gewählt werden. Zudem kann für die Zeitdifferenz zwischen dem zeitlichen Beginn der Verschlechterung des Referenzverhaltens und dem Auftreten der Fehlfunktion ein Mittelwert zwischen der Zeitdifferenz zwischen dem Beginn der Verschlechterung der Funktion der ersten Vorrichtung und dem Auftreten der Fehlfunktion der ersten Vorrichtung und der Zeitdifferenz zwischen dem Beginn der Verschlechterung der Funktion der dritten Vorrichtung und dem Auftreten der Fehlfunktion der dritten Vorrichtung gewählt werden.

Bei dieser Ausführungsform wird das Referenzverhalten, das aufgrund des ersten und des dritten zeitlichen Verhaltens der ersten und der dritten Vorrichtung ermittelt wurde, zur Abschätzung eines Zeitpunktes einer Fehlfunktion der zweiten Vorrichtung verwendet. Folglich wird ab dem zeitlichen Beginn der Verschlechterung der Funktion der zweiten Vorrichtung die gemittelte Zeitspanne verwendet, um das Auftreten der Fehlfunktion in der Zukunft abzuschätzen.

Im Datenspeicher 41 sind Informationen abgelegt, welche Vorrichtung als wenigstens ähnlich oder identisch angesehen werden, um für die Bildung des zeitlichen Referenzverhaltens und/oder für die Abschätzung des Zeitpunktes für das Auftreten einer Fehlfunktion anhand des gebildeten Referenzverhaltens verwendet werden können. Zudem sind die technischen Zustände, d.h. die Zustände der Vorrichtungen und/oder die technischen Parameter im Datenspeicher 41 festgelegt, die für die Bildung der ersten, zweiten und dritten zeitlichen Verhalten der Vorrichtungen verwendet werden können.

Die Recheneinheit 40 ist ausgebildet, um abhängig von den Messwerten der Sensoren 12, 22, 33 ein zeitliches Verhalten eines Messwertes für die Umgebung einer Vorrichtung zu ermitteln. Das zeitliche Messwertverhalten
der Vorrichtungen kann bei der Ermittlung des zeitlichen Referenzverhaltens berücksichtigt werden. Dazu sind entsprechende Formeln und/oder Algorithmen im Datenspeicher 41 abgelegt. Zudem kann die Recheneinheit 40 ausgebildet sein, um anhand des zeitlichen Verhaltens eines Messwertes ein zeitliches Referenzmesswertverhalten zu bilden. Dazu sind entsprechende Vorgaben, Formeln und/oder Algorithmen im Datenspeicher 41 abgelegt. Das zeitliche Messwertverhalten kann gemäß abgespeicherten Funktionen als Bewertungsfaktor verwendet werden, um den Zeitpunkt des Auftretens der Verschlechterung der Funktion festzulegen.

Zudem entnimmt die Recheneinheit 40 dem Datenspeicher 41 Informationen über eine örtliche Umgebungsbedingung der Vorrichtung. Beispielsweise kann dabei hinterlegt sein, ob eine Vorrichtung in einem Tunnel, in einem Gebäude, an einem Bahngleis oder in einem Zug angeordnet ist. Auch diese örtliche Umgebungsbedingung kann von der Recheneinheit 40 bei der Bildung des Referenzverhaltens und/oder bei der Abschätzung des Zeitpunktes für das Auftreten einer Fehlfunktion bei der zweiten Vorrichtung berücksichtigt werden. Für die Art und Weise der Berücksichtigung der Umgebungsbedingungen sind entsprechende Vorschriften, Formeln und/oder Algorithmen im Datenspeicher 41 abgelegt. Die örtliche Umgebungsbedingung kann gemäß abgespeicherten Funktionen als Bewertungsfaktor verwendet werden, um den Zeitpunkt des Auftretens der Verschlechterung der Funktion festzulegen.

Zudem ist die Recheneinheit 40 ausgebildet, um über den Steuerausgang 43 vor dem abgeschätzten Zeitpunkt für das Auftreten einer Fehlfunktion einen Hinweis für eine Wartung der zweiten Vorrichtung auszugeben. Dazu kann eine Anzeige 50 verwendet werden, die entweder im Bereich der Recheneinheit 40 angeordnet ist und beispielsweise von einem Bedienpersonal überwacht wird. Zudem kann die Anzeige 50 auch im Bereich der Vorrichtungen angeordnet sein und dort von einem Bedienpersonal überwacht werden. Weiterhin ist die Recheneinheit 40 ausgebildet, um über den Steuerausgang 43 automatisch eine Wartung der zweiten Vorrichtung durchzuführen. Diese automatische Wartung wird vor dem abgeschätzten Zeitpunkt des Auftretens der Fehlfunktion der zweiten Vorrichtung durchgeführt.

Das Referenzverhalten kann beispielsweise durch eine Mittelung des ersten und des dritten zeitlichen Verhaltens vorgenommen werden. Dabei können einzelne Werte der technischen Zustände und/oder eine Kennlinie, die durch die ermittelten Zustände der Vorrichtungen gebildet wird, gemittelt werden. Abhängig von der gewählten Ausführungsform können für die Bildung des Referenzverhaltens technische Zustände innerhalb einer festgelegten Zeitspanne vor dem Zeitpunkt des Auftretens der Fehlfunktion der ersten und/oder der dritten Vorrichtung verwendet werden. Die Zeitspanne kann von der Art der Vorrichtung und/oder vom Messverhalten der Vorrichtung und/oder von der Umgebungsbedingung abhängen. Dazu sind entsprechende Formeln und/oder Algorithmen abgelegt. Somit ist es möglich, die Anzahl der zu berücksichtigten Zustände der Vorrichtungen zu begrenzen. Auf diese Weise wird Rechenkapazität eingespart. Zudem kann das Referenzverhalten durch die Berücksichtigung einer begrenzten zeitlichen Vergangenheit eine präzisere Aussage über den Zeitpunkt der Fehlfunktion der zweiten Vorrichtung ermöglichen.

FIG 2 zeigt in einer schematischen Darstellung einen Programmablauf zur Durchführung des Verfahrens zum Überprüfen einer technischen Funktion einer elektrischen und/oder mechanischen Vorrichtung eines Eisenbahnsystems. Dabei wird bei Programmpunkt 100 über den Dateneingang 42 von der Recheneinheit 40 in zeitlichen Abständen der technische Zustand der ersten und der zweiten Vorrichtung erfasst. Die erfassten technischen Zustände der ersten und der zweiten Vorrichtung werden von der Recheneinheit 40 bei einem folgenden Programmpunkt 110 im Datenspeicher 41 abgelegt. Bei einem folgenden Programmpunkt 120 wird von der Recheneinheit 40 eine Fehlfunktion der ersten Vorrichtung erfasst. Anschließend wird bei Programmpunkt 130 anhand der abgespeicherten technischen Zustände der ersten Vorrichtung ein zeitliches Referenzverhalten ermittelt. In einem einfachen Fall stellen die erfassten technischen Zustände der ersten Vorrichtung das Referenzverhalten dar.

Bei einem folgenden Programmpunkt 140 werden die gespeicherten technischen Zustände der zweiten Vorrichtung mit dem Referenzverhalten verglichen. Dazu können verschiedene Methoden verwendet werden. Beispielsweise kann das Referenzverhalten in Form einer zeitlichen Kennlinie des technischen Zustandes über die Zeit festgelegt sein. In dieser Ausführungsform wird anhand der gespeicherten technischen Zustände der zweiten Vorrichtung eine zweite Kennlinie gebildet. Zudem wird bei der Referenzkennlinie der zeitliche Beginn der Verschlechterung der Funktion der Vorrichtung ermittelt, wie bereits erläutert. Die Recheneinheit 40 überprüft nun, welcher Zeitpunkt der zweiten Kennlinie der zweiten Vorrichtung dem zeitlichen Beginn der Verschlechterung der Funktion der zweiten Vorrichtung entspricht. Dazu wird die Form der Referenzkennlinie am Zeitpunkt des Beginns der Verschlechterung der ersten Vorrichtung mit der Form der Kennlinie der zweiten Vorrichtung verglichen. Der Zeitpunkt, an dem die zweite Kennlinie die gleiche oder in vorgegebenen Grenzen die ähnliche Form aufweist, wird als Zeitpunkt des Beginns der Verschlechterung der Funktion der zweiten Vorrichtung festgelegt.

Zudem wird von der Steuereinheit die Zeitdifferenz zwischen dem Zeitpunkt des Beginns der Verschlechterung der Funktion ersten Vorrichtung und dem Zeitpunkt des Auftretens der Fehlfunktion der ersten Vorrichtung ermittelt. Diese Zeitdifferenz wird zu dem Zeitpunkt des Beginns der Verschlechterung der Funktion der zweiten Vorrichtung addiert und somit für die Zukunft der Zeitpunkt abgeschätzt, bei dem das Auftreten einer Fehlfunktion der zweiten Vorrichtung erwartet wird.

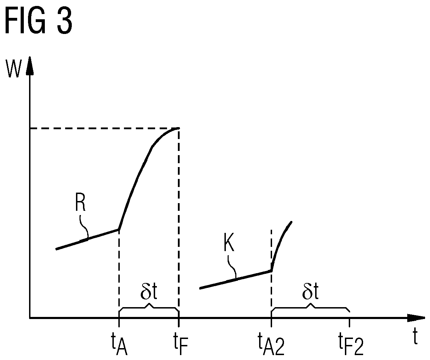

FIG 3 zeigt in einer schematischen Darstellung ein Diagramm, bei der eine Referenzkennlinie R über die Zeit t aufgetragen ist. Dabei sind die Werte W der technischen Zustände der ersten Vorrichtung über die Zeit t aufgetragen. Zum Zeitpunkt tF wurde die erste Fehlfunktion der ersten Vorrichtung ermittelt. Zudem wird anhand eines vorgegebenen Verfahrens ein Zeitpunkt tA, bei dem die Referenzkennlinie eine vorgegebene Steigungsänderung aufweist, als Beginn der Verschlechterung erkannt. Zudem ermittelt die Recheneinheit 40 die zeitliche Differenz δt zwischen dem Fehlerzeitpunkt tF der Referenzkennlinie und dem Zeitpunkt tA der Referenzkennlinie, zu dem der Fehler der ersten Vorrichtung aufgetreten ist.

Zudem ist im Diagramm eine Kennlinie K eingezeichnet, die anhand der erfassten technischen Zustände der zweiten Vorrichtung gebildet wird. Die Recheneinheit prüft die Kennlinie K auf die vorgegebene Steigungsänderung, die den Beginn einer Verschlechterung der Funktion anzeigt, wie bei der Referenzkennlinie R. Der Zeitpunkt, zu dem die vorgegebene Steigungsänderung auf der zweiten Kennlinie K auftritt, wird von der Recheneinheit als zeitlicher Beginn tA2 der Verschlechterung der Funktion der zweiten Vorrichtung festgelegt. Nun wird angenommen, dass die zweite Vorrichtung ein ähnliches technisches Verhalten wie die erste Vorrichtung aufweist. Folglich addiert die Recheneinheit 40 die zuvor ermittelte zeitlichen Differenz δt zwischen dem Fehlerzeitpunkt tF und dem Zeitpunkt tA der Fehlfunktion der ersten Vorrichtung auf den zeitlichen Beginn tA2 der Verschlechterung der Funktion der zweiten Vorrichtung und ermittelt den Zeitpunkt tF2, an dem die Fehlfunktion der zweiten Vorrichtung erwartet wird. Die Zeitspanne δt gibt in die Zukunft gesehen den Zeitpunkt an, in dem die zweite Vorrichtung eine Fehlfunktion aufweisen wird.

Abhängig von der gewählten Ausführungsform kann für das Erkennen des zeitlichen Beginns tA der Verschlechterung der Funktion in dem zeitlichen Referenzverhalten auch eine festgelegte Änderung des technischen Zustandes der ersten Vorrichtung verwendet werden. Beispielsweise kann eine vorgegebene Änderung des technischen Zustandes um mehr als 10% innerhalt eines festgelegten Zeitraums verwendet werden. Es wird nun davon ausgegangen, dass die vorgegebene Änderung des technischen Zustandes auch bei der zweiten Vorrichtung die Entwicklung einer Beeinträchtigung der Funktion der zweiten Vorrichtung anzeigt und sich die zweite Vorrichtung analog zur ersten Vorrichtung verhalten wird. Erkennt nun die Recheneinheit 40 anhand der erfassten technischen Zustände der zweiten Vorrichtung ebenfalls die vorgegebene Änderung, so kann die Recheneinheit 40 den Zeitpunkt des Auftretens der Fehlfunktion der zweiten Vorrichtung in die Zukunft anhand der Zeitspanne δt abschätzen.

Abhängig von der gewählten Ausführungsform können verschiedene vorgegebene Kennlinienformen, Kennlinienverläufe, Kennliniensteigungen, Änderungen von aufeinander folgenden Zuständen der ersten Vorrichtung bzw. des Referenzverhaltens den Beginn einer Verschlechterung der Funktion der ersten Vorrichtung anzeigen. In analoger Weise können diese vorgegebenen Änderungen bei dem zeitlichen Verhalten der zweiten Vorrichtung gesucht werden und durch einen Vergleich mit dem Referenzverhalten die Zeit in die Zukunft abgeschätzt werden, zu welcher die Fehlfunktion in der zweiten Vorrichtung auftreten wird. Abhängig von der gewählten Ausführungsform kann für jede einzelne Vorrichtung mit Hilfe der erfassten technischen Zustände der Vorrichtung eine Referenzliste im Datenspeicher abgelegt werden. Zudem kann abhängig von der gewählten Ausführungsform für einen Vorrichtungstypen eine einzige Referenzliste anhand mehrerer zeitlich erfassten Zustände mehrerer Vorrichtungen ermittelt werden.

Abhängig von der gewählten Ausführungsform können bei der Ermittlung des Verhaltens einer Vorrichtung und/oder der Ermittlung des Referenzverhaltens auch Messwerte der Umgebungsbedingung, insbesondere die Temperatur und/oder die Feuchtigkeit und/oder die Gaszusammensetzung und/oder die Sonneneinstrahlung berücksichtigt werden. Zudem können abhängig von der gewählten Ausführungsform für die Ermittlung des Verhaltens einer Vorrichtung und/oder für die Ermittlung eines Referenzverhaltens örtliche Umgebungsbedingungen der Vorrichtungen berücksichtigt werden.

Abhängig von der gewählten Ausführung können die Referenzkennlinie R abhängig von einem vergangenen ersten zeitlichen Verhalten der ersten Vorrichtung ermittelt worden sein und die Kennlinie K kann ein aktuelles erstes zeitliches Verhalten der ersten Vorrichtung darstellen. Somit kann das zukünftige Auftreten einer Fehlfunktion der ersten Vorrichtung aus dem historischen zeitlichen Verhalten der ersten Vorrichtung, das in der Referenzkennlinie R abgebildet ist, vorhergesagt werden.

In einer weiteren Ausführungsform, die im Wesentlichen analog zu dem Verfahren der FIG 2 ausgeführt wird, werden bei Programmpunkt 100 zusätzlich in zeitlichen Abständen technische Zustände einer dritten Vorrichtung erfasst und im folgenden Programmpunkt 110 im Datenspeicher 41 abgelegt. Bei Programmpunkt 120 wird zudem überprüft, ob eine Fehlfunktion der dritten Vorrichtung erfasst wird. Ist dies der Fall, so werden zur Bildung des Referenzverhaltens nicht nur die gespeicherten technischen Zustände der ersten Vorrichtung, sondern auch die gespeicherten technischen Zustände der zweiten Vorrichtung verwendet. Dazu sind entsprechende Verfahren, Formeln und/oder Algorithmen im Datenspeicher 41 abgelegt, die von der Recheneinheit 40 verwendet werden, um das Referenzverhalten präzise zu ermitteln. Auch bei der dritten Vorrichtung können zusätzlich zu den technischen Zuständen ein zeitliches Verhalten eines Messwertes für eine Umgebungsbedingung, insbesondere für eine Temperatur und/oder eine Feuchtigkeit und/oder eine Gaszusammensetzung und/oder eine Sonneneinstrahlung am Ort der Vorrichtung erfasst und als zeitliches Messwertverhalten der Vorrichtung abgespeichert werden. Zudem kann das zeitliche Messwertverhalten der dritten Vorrichtung zusätzlich bei der Ermittlung des zeitlichen Referenzverhaltens berücksichtigt werden. In analoger Weise kann auch eine vorgegebene örtliche Umgebungsbedingung der dritten Vorrichtung bei der Bildung des zeitlichen Verhaltens und/oder bei der Bildung des zeitlichen Referenzverhaltens mit Hilfe der dritten Vorrichtung berücksichtigt werden.

Bei dem folgenden Programmpunkt 150 wird ein Hinweis für eine Wartung der zweiten Vorrichtung vor dem Zeitpunkt der erwarteten Fehlfunktion von der Recheneinheit 40 über den Steuerausgang 43 ausgegeben, und insbesondere mit Hilfe der Anzeige 50 angezeigt. Aufgrund dieses Hinweises kann ein Bedienpersonal die Wartung und/oder Reparatur der Vorrichtung, bei der eine Fehlfunktion erwartet wird, durchführen. In einer weiteren Ausführungsform kann zusätzlich oder anstelle der Ausgabe des Warnhinweises die Recheneinheit 40 bei Programmpunkt 150 über den Steuerausgang 53 eine direkte Verbindung zu der zweiten Vorrichtung aufbauen und automatisch eine Wartung und/oder Reparatur oder Änderung der Funktion der zweiten Vorrichtung oder eine Abschaltung der zweiten Vorrichtung durchführen.

In der Ausführungsform, in der die Referenzkennlinie R und die Kennlinie K von der ersten Vorrichtung stammen, kann bei Programmpunkt 150 ein Hinweis für eine Wartung der ersten Vorrichtung vor dem Zeitpunkt der erwarteten Fehlfunktion von der Recheneinheit 40 über den Steuerausgang 43 ausgegeben, und insbesondere mit Hilfe der Anzeige 50 angezeigt werden. Aufgrund dieses Hinweises kann ein Bedienpersonal die Wartung und/oder Reparatur der Vorrichtung, bei der eine Fehlfunktion erwartet wird, durchführen. In einer weiteren Ausführungsform kann zusätzlich oder anstelle der Ausgabe des Warnhinweises die Recheneinheit 40 bei Programmpunkt 150 über den Steuerausgang 53 eine direkte Verbindung zu der ersten Vorrichtung aufbauen und automatisch eine Wartung und/oder Reparatur oder Änderung der Funktion der ersten Vorrichtung oder eine Abschaltung der ersten Vorrichtung durchführen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Computerimplementiertes Verfahren zum Überprüfen einer technischen Funktion einer elektrischen und/oder mechanischen ersten Vorrichtung eines Eisenbahnsystems, insbesondere einer ersten Vorrichtung eines Zuges oder einer Gleisinfrastruktur, wobei ein technischer Zustand der ersten Vorrichtung in zeitlichen Abständen erfasst wird, wobei die erfassten technischen Zustände der ersten Vorrichtung als erstes zeitliches Verhalten abgespeichert werden, wobei ein technischer Zustand einer zweiten Vorrichtung des Eisenbahnsystems in zeitlichen Abständen erfasst wird, wobei die erfassten technischen Zustände der zweiten Vorrichtung als zweites zeitliches Verhalten abgespeichert werden, wobei die zweite Vorrichtung gemäß wenigstens einem technischen Parameter ähnlich oder identisch zur ersten Vorrichtung ist, wobei bei Auftreten einer ersten Fehlfunktion der ersten Vorrichtung das erste zeitliche Verhalten als zeitliches Referenzverhalten ermittelt wird, und wobei anhand des Referenzverhaltens und anhand des zweiten zeitlichen Verhaltens ein Zeitpunkt abgeschätzt wird, bei dem eine Fehlfunktion der zweiten Vorrichtung auftreten wird.

2. Verfahren nach Anspruch 1,
wobei ein technischer Zustand einer dritten Vorrichtung in zeitlichen Abständen erfasst wird, wobei die erfassten technischen Zustände der dritten Vorrichtung als drittes zeitliches Verhalten abgespeichert werden, wobei die dritte Vorrichtung gemäß wenigstens einem technischen Parameter ähnlich oder identisch zur ersten Vorrichtung ist, wobei bei Auftreten einer dritten Fehlfunktion der dritten Vorrichtung, die gemäß wenigstens einem Parameter ähnlich oder identisch zur ersten Fehlfunktion ist, aus dem ersten und dem dritten zeitlichen Verhalten das zeitliche Referenzverhalten ermittelt wird, und wobei anhand des Referenzverhaltens und anhand des zweiten zeitlichen Verhaltens ein Zeitpunkt abgeschätzt wird, bei dem eine Fehlfunktion bei der zweiten Vorrichtung auftreten wird.

3. Verfahren nach Anspruch 2,
wobei die erste, die zweite und die dritte Vorrichtung in Bezug auf eine elektrische Schaltung und/oder eine mechanische Konstruktion wenigstens ähnlich oder identisch ausgebildet sind.

4. Verfahren nach einem der Ansprüche 2 oder 3,
wobei die Fehlfunktionen der ersten, der zweiten und der dritten Vorrichtung wenigstens ähnlich oder identisch ausgebildet sind.

5. Verfahren nach einem der Ansprüche 1 bis 4,
wobei zusätzlich zu den technischen Zuständen der Vorrichtungen wenigstens ein zeitliches Verhalten eines Messwertes für eine Umgebungsbedingung, insbesondere für eine Temperatur und/oder eine Feuchtigkeit und/oder eine Gaszusammensetzung und/oder eine Sonneneinstrahlung am Ort der Vorrichtung erfasst und als zeitliches Messwertverhalten der Vorrichtung abgespeichert wird, wobei das zeitliche Messwertverhalten der Vorrichtungen zusätzlich bei der Ermittlung des zeitlichen Referenzverhaltens berücksichtigt wird, insbesondere als zeitliches Referenzmesswertverhalten verwendet wird.

6. Verfahren nach einem der Ansprüche 1 bis 5,
wobei zusätzlich zu den technischen Zuständen der Vorrichtungen wenigstens eine örtliche Umgebungsbedingung der Vorrichtungen abgespeichert wird, wobei die Umgebungsbedingungen der Vorrichtungen zusätzlich bei der Ermittlung des zeitlichen Referenzverhaltens berücksichtigt werden.

7. Verfahren nach einem der Ansprüche 1 bis 6,
wobei vor dem abgeschätzten Zeitpunkt, zu dem bei der zweiten Vorrichtung eine Fehlfunktion erwartet wird, ein Hinweis für eine Wartung der zweiten Vorrichtung ausgeben wird und/oder automatisch eine Wartung der zweiten Vorrichtung durchgeführt wird.

8. Verfahren nach einem der Ansprüche 1 bis 7,
wobei als technischer Zustand ein Strom und/oder eine Spannung und/oder eine Temperatur der Vorrichtung und/oder eine Geschwindigkeit eines bewegbaren Teils der Vorrichtung umfasst sind.

9. Verfahren nach einem der Ansprüche 2 bis 8,
wobei zur Ermittlung des Referenzverhaltens eine Mittelung zwischen dem ersten und dem dritten zeitlichen Verhalten vorgenommen wird.

10. Verfahren nach einem der Ansprüche 2 bis 9,
wobei abhängig von einem vorgegebenen Verfahren ein Zeitpunkt am zeitlichen Referenzverhalten ermittelt wird, der den Beginn einer Verschlechterung der Funktion der ersten Vorrichtung festlegt, wobei eine Zeitspanne zwischen dem Beginn der Verschlechterung und der ersten Fehlfunktion der ersten Vorrichtung ermittelt wird, wobei durch einen Vergleich des zeitlichen Referenzverhaltens mit dem zweiten zeitlichen Verhalten ein zweiter Zeitpunkt ermittelt wird, ab dem das Auftreten einer Fehlfunktion bei der zweiten Vorrichtung erkennbar ist, und wobei der Zeitpunkt des Auftretens der Fehlfunktion der zweiten Vorrichtung durch den zweiten Zeitpunkt und die Zeitspanne abgeschätzt wird.

11. Verfahren nach einem der vorhergehenden Ansprüche,
wobei die erste, die zweite und/oder die dritte Vorrichtung eine Weiche für ein Zuggleis, eine Signalanzeige, ein Gleisbett und/oder ein Achszählsystem für einen Zug darstellt.

12. Computerprogramm, umfassend Befehle, die bei der Ausführung des Programms durch einen Computer diesen veranlassen, das Verfahren nach einem der Ansprüche 1 bis 11 auszuführen.

13. Vorrichtung zum Überprüfen einer technischen Funktion einer elektrischen und/oder mechanischen Vorrichtung eines Eisenbahnsystems, insbesondere eines Zuges oder einer Gleisinfrastruktur, mit einer Recheneinheit (40), einem Datenspeicher (41), einem Dateneingang (42) und einem Steuerausgang (43), wobei über den Dateneingang (42) technische Zustände einer ersten Vorrichtung (10) empfangen werden, wobei die Recheneinheit (40) die erfassten technischen Zustände als erstes zeitliches Verhalten im Datenspeicher (41) speichert, wobei über den Dateneingang (42) technische Zustände einer zweiten Vorrichtung (20) empfangen werden, wobei die Recheneinheit (40) die erfassten technischen Zustände der zweiten Vorrichtung (20) als zweites zeitliches Verhalten im Datenspeicher (41) speichert, wobei die zweite Vorrichtung (20) gemäß wenigstens einem technischen Parameter ähnlich oder identisch zur ersten Vorrichtung ist, wobei über den Dateneingang (42) eine erste Fehlfunktion der ersten Vorrichtung (10) empfangen wird, wobei die Recheneinheit (40) nach dem Empfang der ersten Fehlfunktion der ersten Vorrichtung (10) das erste zeitliche Verhalten als zeitliches Referenzverhalten festlegt, wobei die Recheneinheit (40) anhand des Referenzverhaltens und anhand des zweiten zeitlichen Verhaltens einen Zeitpunkt abschätzt, bei dem eine Fehlfunktion in der zweiten Vorrichtung (20) auftreten wird.

14. Vorrichtung nach Anspruch 13,
wobei von der Recheneinheit (40) über den Dateneingang (42) technische Zustände einer dritten Vorrichtung (30) empfangen werden, wobei die Recheneinheit (40) die erfassten technischen Zustände der dritten Vorrichtung (30) als drittes zeitliches Verhalten im Datenspeicher (41) speichert, wobei die dritte Vorrichtung (30) gemäß wenigstens einem technischen Parameter ähnlich oder identisch zur ersten Vorrichtung (10) ist, wobei bei Empfang eines Auftretens einer dritten Fehlfunktion der dritten Vorrichtung (30) über den Dateneingang (42), die gemäß wenigstens einem Parameter ähnlich oder identisch zur ersten Fehlfunktion ist, die Recheneinheit (40) aus dem ersten und dem dritten zeitlichen Verhalten das zeitliche Referenzverhalten ermittelt und im Datenspeicher speichert, wobei die Recheneinheit (40) anhand des Referenzverhaltens und anhand des zweiten zeitlichen Verhaltens einen Zeitpunkt abschätzt, bei dem eine Fehlfunktion in der zweiten Vorrichtung (20) auftreten wird.
